# EUROPEAN PATENT APPLICATION

(11) **EP 4 593 052 A1**
(43) Date of publication of application: **30.07.2025**
(21) Application number: 25153505.0
(22) Date of filing: 23.01.2025
(51) Int. Cl.: H01H 1/58, H01H 50/04, H01H 50/14, H01H 50/02

(54) **RELAY, POWER DISTRIBUTION APPARATUS, AND CHARGING PILE**

(30) Priority: 23.01.2024 CN 202410098052
(71) Applicant: Huawei Digital Power Technologies Co., Ltd., Shenzhen, Guangdong 518043 (CN)
(72) Inventor: WANG, Qiao, Shenzhen, Guangdong, 518043 (CN); PAN, Denghai, Shenzhen, Guangdong, 518043 (CN); WANG, Yuchuan, Shenzhen, Guangdong, 518043 (CN); YANG, Zezhou, Shenzhen, Guangdong, 518043 (CN); TANG, Zhuo, Shenzhen, Guangdong, 518043 (CN)
(74) Representative: Maiwald GmbH

(57) **Abstract**

Embodiments of this application provide a relay, a power distribution apparatus, and a charging pile. The relay includes at least one group of main lead-out pin components and at least one group of main contact components, each group of main contact components is located inside the relay, each group of main lead-out pin components is located outside the relay, each group of main lead-out pin components is connected to the main contact components, and each group of main lead-out pin components is configured to connect to a circuit to control connection or disconnection of the circuit. Each group of main lead-out pin components includes a long lead-out pin and a short lead-out pin, and a length of the long lead-out pin is greater than a length of the short lead-out pin.

## Description

### TECHNICAL FIELD

This application relates to the field of new energy technologies, and in particular, to a relay, a power distribution apparatus, and a charging pile.

### BACKGROUND

Rapid development of the new energy industry has raised higher requirements for power distribution technologies. As one type of conventional power distribution switches, relays are developing toward a high withstand voltage, a large through current, high reliability, and miniaturization in applications of the new energy industry. This makes designs of forms, specifications, pin layouts, and the like of the relays increasingly important.

### SUMMARY

Embodiments of this application provide a relay, a power distribution apparatus, and a charging pile. The relay provided in embodiments of this application has a strong through-current capability. After the relay is assembled with a PCB, heat dissipation capabilities of a pin of the relay and the PCB can be improved.

According to a first aspect, an embodiment of this application provides a relay. The relay includes at least one group of main lead-out pin components and at least one group of main contact components, each group of main contact components is located inside the relay, each group of main lead-out pin components is located outside the relay, each group of main lead-out pin components is connected to the main contact components, and each group of main lead-out pin components is configured to connect to a circuit to control connection or disconnection of the circuit. The relay includes a bottom wall, the bottom wall includes an inner surface facing the inside of the relay and an outer surface facing the outside of the relay, each group of main lead-out pin components is located on the outer surface of the bottom wall, each group of main lead-out pin components includes a long lead-out pin and a short lead-out pin, and a length of the long lead-out pin is greater than a length of the short lead-out pin in a direction from the inner surface of the bottom wall to the outer surface of the bottom wall.

In a possible implementation, the short lead-out pin is configured to connect to a through-current path on a top surface of a printed circuit board PCB or inside the PCB through a via on the PCB, and the long lead-out pin is configured to connect to a copper bar or an aluminum bar on a bottom surface of the PCB through a via on the PCB.

In this embodiment of this application, the long lead-out pin is connected to the copper bar or the aluminum bar on the bottom surface of the PCB, and because the copper bar or the aluminum bar has a strong through-current capability, a through-current capability of the PCB can be improved, and through-current density of the PCB can be increased. In addition, because the copper bar has a large area and good heat conductivity and heat uniformity, when the long lead-out pin is soldered to the copper bar, the copper bar can quickly disperse heat of a solder joint between the long lead-out pin and the copper bar, to facilitate assembly of the long lead-out pin with the PCB.

In a possible implementation, the bottom wall is in a quadrilateral shape, the bottom wall includes a first edge and a second edge that are disposed opposite to each other and a third edge and a fourth edge that are disposed opposite to each other, the at least one group of main lead-out pin components includes two groups of main lead-out pin components, and long lead-out pins and short lead-out pins in the two groups of main lead-out pin components are arranged at intervals in a circumferential direction of the bottom wall. One long lead-out pin and one short lead-out pin in the two groups of main lead-out pin components are arranged close to the first edge, the other long lead-out pin and the other short lead-out pin in the two groups of main lead-out pin components are arranged close to the second edge, and in a direction from the first edge to the second edge, a projection of the one long lead-out pin does not overlap a projection of the other long lead-out pin, and a projection of the one short lead-out pin does not overlap a projection of the other short lead-out pin. Alternatively, the short lead-out pins in the two groups of main lead-out pin components are disposed close to the first edge and the second edge respectively, and the long lead-out pins in the two groups of main lead-out pin components are disposed close to the third edge and the fourth edge respectively.

In this disposing manner, when the PCB includes a plurality of current transmission paths (a plurality of current input paths and a plurality of current output paths), a problem that the plurality of current transmission paths need to avoid each other can be resolved. This facilitates routing on the PCB, improves utilization of the PCB, and reduces a size of the PCB.

In a possible implementation, when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, in a direction from the third edge to the fourth edge, a projection of the one long lead-out pin overlaps a projection of the one short lead-out pin, and a projection of the other long lead-out pin overlaps a projection of the other short lead-out pin.

In this disposing manner, a structure of the relay can be regular, and a volume of the relay can be reduced. This facilitates a regular layout of the PCB, and improves the utilization of the PCB.

In a possible implementation, in the direction from the first edge to the second edge, the projection of the one long lead-out pin overlaps the projection of the other short lead-out pin, and the projection of the one short lead-out pin overlaps the projection of the other long lead-out pin.

In this disposing manner, the structure of the relay can be regular, the volume of the relay can be reduced, the plurality of current input paths on the PCB can be disposed independently of each other and in parallel, and the plurality of current output paths on the PCB can be disposed independently of each other and in parallel. This facilitates an overall layout of the PCB, and improves the utilization of the PCB.

In a possible implementation, at least one first insulation partition is disposed between the one long lead-out pin and the one short lead-out pin, and at least one second insulation partition is disposed between the other long lead-out pin and the other short lead-out pin.

In other words, at least one insulation partition is disposed between a long lead-out pin and a short lead-out pin that are close to each other. The insulation partition can increase a creepage distance between the long lead-out pin and the short lead-out pin that are close to each other, and reduce a risk of a short circuit between the two close lead-out pins, to improve use safety of the relay.

In a possible implementation, a first groove is provided between the one long lead-out pin and the one short lead-out pin, and a second groove is provided between the other long lead-out pin and the other short lead-out pin.

The first groove and the second groove are configured to accommodate an insulation partition. In this case, an insulation partition may be disposed on the PCB. When the relay is assembled with the PCB, the insulation partition may be inserted into a groove, to increase a creepage distance between two close lead-out pins, so as to improve use safety of the relay.

In a possible implementation, when the short lead-out pins in the two groups of main lead-out pin components are disposed close to the first edge and the second edge respectively, and the long lead-out pins in the two groups of main lead-out pin components are disposed close to the third edge and the fourth edge respectively, the projections of the two short lead-out pins in the two groups of main lead-out pin components overlap in the direction from the first edge to the second edge, and projections of the two long lead-out pins in the two groups of main lead-out pin components overlap in a direction from the third edge to the fourth edge.

In this disposing manner, the structure of the relay can be regular, the volume of the relay can be reduced, the plurality of current input paths on the PCB can be disposed independently of each other and in parallel, and the plurality of current output paths on the PCB can be disposed independently of each other and in parallel. This facilitates the overall layout of the PCB, and improves the utilization of the PCB.

In a possible implementation, the relay further includes a coil and a group of coil lead-out pin components, and the coil lead-out pin components are connected to the coil. The at least one group of main contact components includes two groups of main contact components, and the two groups of main contact components are connected to the two groups of main lead-out pin components in one-to-one correspondence. Each group of main contact components includes a movable contact and a stationary contact, the long lead-out pin in each group of main lead-out pin components is connected to one of the movable contact and the stationary contact in the corresponding main contact components, and the short lead-out pin in each group of main lead-out pin components is connected to the other of the movable contact and the stationary contact in the corresponding main contact components. The coil is configured to drive the movable contact and the stationary contact in each of the two groups of main contact components to act with each other.

In this disposing manner, only one coil is required to drive the two groups of main contact components, so that an area of the PCB occupied by the relay can be reduced, and control logic of the relay can be simplified.

In a possible implementation, the relay further includes a group of auxiliary contact components and a group of auxiliary contact lead-out pin components, the group of auxiliary contact components is located inside the relay, the group of auxiliary contact lead-out pin components is located outside the relay, and the group of auxiliary contact lead-out pin components is connected to the group of auxiliary contact components. The group of auxiliary contact components includes an auxiliary movable contact and an auxiliary stationary contact, and the auxiliary contact components are configured to be mechanically linked with each group of main contact components.

In a possible implementation, when a movable contact and a stationary contact that are connected to at least one of the two groups of main lead-out pin components change from an open state to a closed state, a state between the auxiliary movable contact and the auxiliary stationary contact changes; or when a movable contact and a stationary contact that are connected to each of the two groups of main lead-out pin components change from a closed state to an open state, a state between the auxiliary movable contact and the auxiliary stationary contact changes.

For example, a movable contact and a stationary contact that are connected to each group of main lead-out pin components are in a normally open state, and the auxiliary movable contact and the auxiliary stationary contact are in a normally open state. When the coil is energized, if a movable contact and a stationary contact that are connected to at least one of the two groups of main lead-out pin components change from the open state to a closed state, the auxiliary movable contact and the auxiliary stationary contact act relative to each other and change from the open state to a closed state. When the coil changes from being energized to not being energized, if one of the two groups of main lead-out pin components does not change from a closed state to an open state, the auxiliary movable contact and the auxiliary stationary contact are still in the closed state. The auxiliary movable contact and the auxiliary stationary contact act relative to each other and change from the closed state to an open state only when the movable contact and the stationary contact that are connected to each of the two groups of main lead-out pin components change from a closed state to an open state.

In other words, as long as it is detected that the auxiliary movable contact and the auxiliary stationary contact are in a closed state, it can be determined that a movable contact and a stationary contact that are connected to at least one of the two groups of main lead-out pin components of the relay are in a closed state. In this case, another relay connected to a same input line as the relay 60 may be controlled to be in an off state. In this way, when a power distribution apparatus assembled by using a plurality of relays is connected to two electric vehicles at the same time, a short circuit between positive electrodes of the two vehicles or a short circuit between negative electrodes of the two vehicles can be prevented, so that use safety of the relay can be improved, and use safety of a charging pile is further improved.

In a possible implementation, when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, the coil lead-out pin components and the auxiliary contact lead-out pin components are arranged close to the third edge or the fourth edge. Alternatively, when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, the coil lead-out pin components and the auxiliary contact lead-out pin components are located in a center of the bottom wall.

In a possible implementation, when the short lead-out pins in the two groups of main lead-out pin components are disposed close to the first edge and the second edge respectively, and the long lead-out pins in the two groups of main lead-out pin components are disposed close to the third edge and the fourth edge respectively, the coil lead-out pin components and the auxiliary contact lead-out pin components are located in a center of the bottom wall.

In this disposing manner, an area of the bottom wall of the relay can be fully used, and the volume of the relay 60 can be reduced.

In a possible implementation, the relay includes two series units, each series unit includes M groups of main contact components, and the two series units are in one-to-one correspondence with the two groups of main lead-out pin components, where M is an integer greater than or equal to 2. The M groups of main contact components are sequentially connected in series, one contact in a 1^{st} group of main contact components is connected to the short lead-out pin in the main lead-out pin components, and one contact in an M^{th} group of main contact components is connected to the long lead-out pin in the main lead-out pin components.

When a distance between the long lead-out pin and the short lead-out pin is small, if the movable contact and the stationary contact act relative to each other, an arc is generated, and consequently the movable contact and the stationary contact are broken down, and the relay is damaged. In the manner of connecting a plurality of groups of main contact components in series, the distance between the long lead-out pin and the short lead-out pin can be increased, so that generation of an arc between the movable contact and the stationary contact is reduced, and use reliability of the relay is improved.

In a possible implementation, the relay includes two parallel units, each parallel unit includes M groups of main contact components, and the two parallel units are in one-to-one correspondence with the two groups of main lead-out pin components, where M is an integer greater than or equal to 2. The M groups of main contact components are connected in parallel, M contacts in the M groups of main contact components are connected to the short lead-out pin in the main lead-out pin components, and other M contacts in the M groups of main contact components are connected to the long lead-out pin in the main lead-out pin components.

When a current passing through the long lead-out pin and the short lead-out pin is large, a line generates enormous heat. If the movable contact and the stationary contact act relative to each other, the movable contact and the stationary contact are adhered due to excessively high temperature, and consequently the relay 60 cannot work normally. In the manner of connecting a plurality of groups of main contact components in parallel, a current passing through each group of main contact components can be reduced, so that a probability of adhesion between the movable contact and the stationary contact is reduced, and use reliability of the relay is improved.

In a possible implementation, the outer surface of the bottom wall includes at least one protrusion, and a length of each of the at least one protrusion is less than a length of each lead-out pin in each group of main lead-out pin components in the direction from the inner surface to the outer surface.

Currents passing through the PCB and the main lead-out pin components are large, and enormous heat is generated. The protrusion is disposed between the top surface of the PCB and a bottom wall 601-1 of a housing, so that a gap between the bottom wall and the top surface of the PCB can be enlarged. This can increase contact areas between air and both the top surface of the PCB and the main lead-out pin components to facilitate heat dissipation, and further increase through-current density of the relay and the PCB. In addition, after the gap between the bottom wall and the top surface of the PCB is enlarged, a bus bar or a copper bar may be disposed on the top surface of the PCB, and the bus bar and the copper bar may further improve the through-current capability of the PCB.

In a possible implementation, each lead-out pin in each group of main lead-out pin components includes a first side surface and a second side surface that are disposed opposite to each other and a third side surface and a fourth side surface that are disposed opposite to each other, a sum of areas of the first side surface and the second side surface is less than a sum of areas of the third side surface and the fourth side surface, and a projection of the protrusion does not overlap a projection of each lead-out pin in each group of main lead-out pin components in a direction from the first side surface to the second side surface.

During specific disposing, after the relay is assembled with the PCB, the relay and the PCB are further disposed in a sealed cavity by using a housing. To better dissipate heat from the relay and the PCB, an air intake vent and an air exhaust vent may be provided on the housing, and heat is dissipated from the relay and the PCB in an air-based cooling manner. The housing includes a first side wall and a second side wall that are disposed opposite to each other in the direction from the first side surface to the second side surface. The air intake vent and the air exhaust vent may be disposed on the first side wall and the second side wall respectively. In this disposing manner, a projection of the protrusion does not overlap a projection of each lead-out pin in each group of main lead-out pin components in an air flow direction. In other words, the protrusion does not block each group of main lead-out pin components in the air flow direction. In this way, a contact area between air and each lead-out pin in each group of main lead-out pin components can be large, so that efficiency in dissipating heat from each group of main lead-out pin components is improved.

In a possible implementation, at least one movable contact or at least one stationary contact in the at least one group of main contact components includes a plurality of split contacts, the plurality of split contacts are connected in series, at least one long lead-out pin or at least one short lead-out pin in the at least one group of main lead-out pin components includes a plurality of split lead-out pins, the plurality of split lead-out pins are connected to the plurality of split contacts in one-to-one correspondence, and the plurality of split lead-out pins are disposed in parallel with each other.

The design of split lead-out pins can increase a through-current cross-sectional area of the main lead-out pin components, and correspondingly increase a heat dissipation area of the main lead-out pin components. This helps increase the through-current density of the relay 60.

According to a second aspect, an embodiment of this application provides a power distribution apparatus. The power distribution apparatus includes a PCB and a plurality of the relays according to any one of the first aspect or possible implementations of the first aspect Vias are provided between a top surface and a bottom surface of the PCB, and the relays are connected to the PCB through the vias. The top surface of the PCB or the inside of the PCB includes a plurality of groups of through-current paths, the bottom surface of the PCB includes a plurality of groups of copper bars or aluminum bars, each group of through-current paths is configured to receive currents, each group of copper bars or aluminum bars is configured to output currents, each group of through-current paths includes two through-current paths that are configured to receive a positive current and a negative current respectively, and each group of copper bars or aluminum bars includes two copper bars or two aluminum bars that are configured to output a positive current and a negative current respectively. The short lead-out pin is connected to one through-current path in one group of through-current paths through the via, the long lead-out pin is connected to one copper bar or aluminum bar in one group of copper bars or aluminum bars through the via, and the main lead-out pin components are configured to connect or disconnect a current transmission path between the one through-current path and the one copper bar or aluminum bar. The long lead-out pins of at least two of the plurality of the relays are connected to a same group of copper bars or aluminum bars, and the short lead-out pins of the at least two relays are connected to at least two groups of through-current paths in one-to-one correspondence.

The power distribution apparatus formed by assembling the relays according to any one of the first aspect or possible implementations of the first aspect with the PCB can transmit a large current, has a good heat dissipation capability, and is applicable to a scenario in which an electric vehicle is charged with a large current. In addition, the power distribution apparatus has a small volume, so that a volume of a charging pile can be reduced.

According to a third aspect, an embodiment of this application provides a charging pile. The charging pile includes the foregoing power distribution apparatus, a power conversion apparatus, and a plurality of charging interfaces. Each charging interface is configured to connect to an electric vehicle. The power conversion apparatus is configured to output a direct current to the power distribution apparatus, and the power distribution apparatus is configured to distribute the direct current to any one of the charging interfaces.

The power distribution apparatus according to the second aspect is used, so that the charging pile can output a large current to charge an electric vehicle, and the charging pile has a good heat dissipation capability, and is applicable to a scenario in which an electric vehicle is charged with a large current.

### BRIEF DESCRIPTION OF DRAWINGS

FIG. 1 is a diagram of a charging pile according to an embodiment of this application;
FIG. 2 is a diagram of a power conversion apparatus in FIG. 1;
FIG. 3 is another diagram of a power conversion apparatus in FIG. 1;
FIG. 4 is a schematic of a circuit connection of a power distribution apparatus in FIG. 1;
FIG. 5(a) is a diagram of a use scenario of a relay;
FIG. 5(b) is a diagram of a principle of a relay;
FIG. 6(a) is a diagram of a structure of a relay according to an embodiment of this application;
FIG. 6(b) is a diagram of a principle of soldering the relay in FIG. 6(a) to a PCB;
FIG. 7 is a diagram of another structure of a relay according to an embodiment of this application;
FIG. 8 is a diagram of a power distribution apparatus formed by assembling relays with a PCB;
FIG. 9 is a diagram of a principle of connection between the relays and the PCB in FIG. 8;
FIG. 10 is a diagram of still another structure of a relay according to an embodiment of this application;
FIG. 11 is a diagram of still another structure of a relay according to an embodiment of this application;
FIG. 12 is a diagram of another principle of a relay according to an embodiment of this application;
FIG. 13 is a diagram of still another principle of a relay according to an embodiment of this application;
FIG. 14(a) is a cross-sectional view of a relay according to an embodiment of this application;
FIG. 14(b) is a diagram of a principle of the relay shown in FIG. 14(a);
FIG. 15 is a diagram of a charging pile according to an embodiment of this application; and
FIG. 16 is another diagram of a charging pile according to an embodiment of this application.

### DESCRIPTION OF EMBODIMENTS

For ease of understanding, terms in embodiments of this application are first explained.

Connection should be understood in a broad sense. For example, that A is connected to B may mean that A is directly connected to B or that A is indirectly connected to B through an intermediate medium.

The terms "first", "second", and the like in descriptions are merely intended for a purpose of description, and shall not be understood as an indication or implication of relative importance or implicit indication of a quantity of indicated technical features. Therefore, a feature defined by "first", "second", or the like may explicitly or implicitly include one or more features.

Rapid development of the new energy industry has raised higher requirements for power distribution technologies. As one type of conventional power distribution switches, relays are developing toward a high withstand voltage, a large through current, high reliability, and miniaturization in applications of the new energy industry. This makes designs of forms, specifications, pin layouts, and the like of the relays increasingly important.

The following describes a power distribution function of a relay by using a scenario in which a charging pile charges an electric vehicle as an example.

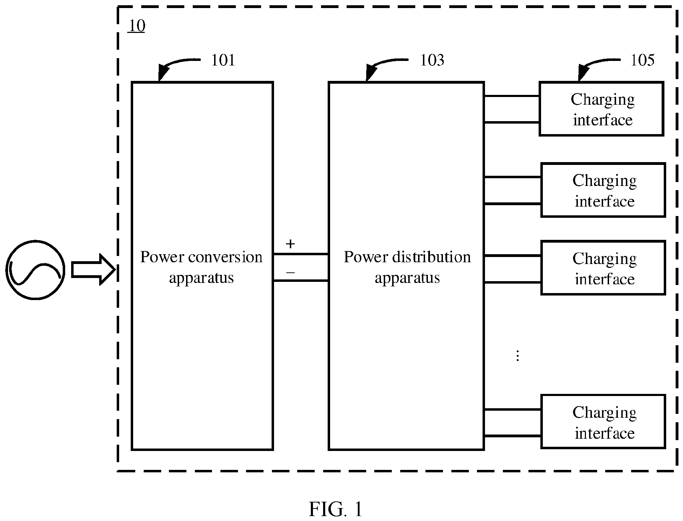

FIG. 1 is a diagram of a charging pile according to an embodiment of this application. The charging pile 10 includes a power conversion apparatus 101, a power distribution apparatus 103, and charging interfaces 105. An input end of the power conversion apparatus 101 is configured to receive an alternating current, an output end of the power conversion apparatus 101 is connected to an input end of the power distribution apparatus 103, an output end of the power distribution apparatus 103 is connected to an input end of the charging interface 105, and an output end of the charging interface 105 is configured to output a direct current. The power conversion apparatus 101 is configured to convert an alternating current into a direct current, the power distribution apparatus 103 is configured to distribute, to the charging interfaces 105, the direct current that is output by the power conversion apparatus 101, and the charging interface is configured to connect to an electric vehicle, so that the electric vehicle can be charged.

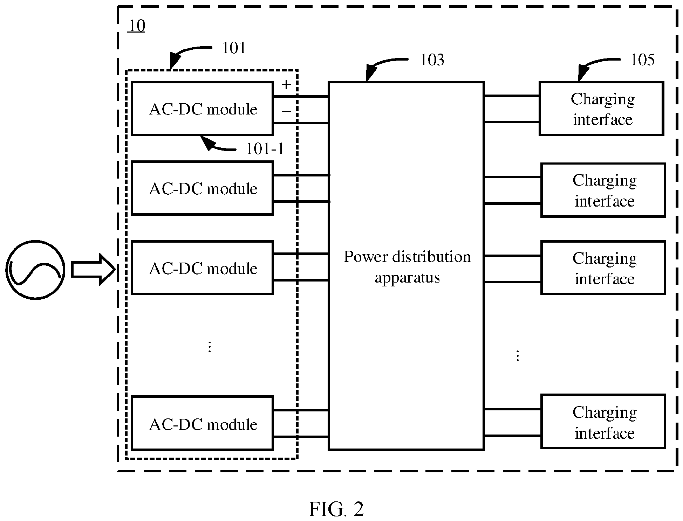

Specifically, FIG. 2 is a diagram of the power conversion apparatus 101 in FIG. 1. The power conversion apparatus 101 includes a plurality of AC-DC modules 101-1. Output ends of the plurality of AC-DC modules 101-1 are connected to a plurality of input ends of the power distribution apparatus 103. The power distribution apparatus 103 is configured to distribute, to the charging interfaces 105, direct currents that are output by the AC-DC modules 101-1.

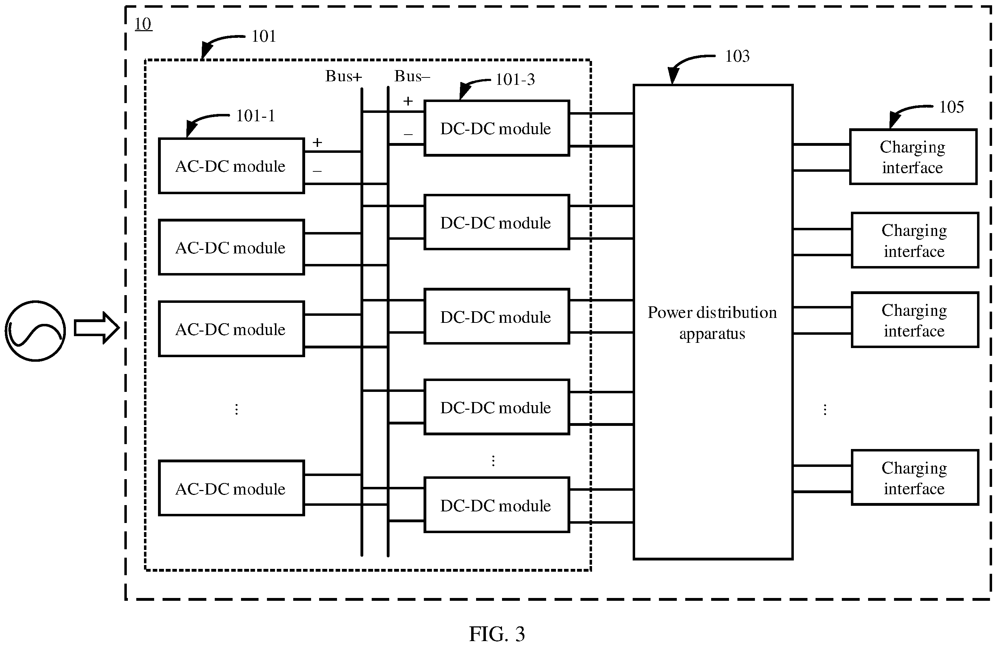

FIG. 3 is another diagram of the power conversion apparatus 101 in FIG. 1. The power conversion apparatus 101 includes a plurality of AC-DC modules 101-1 and a plurality of DC-DC modules 101-3. Output ends of the plurality of AC-DC modules 101-1 are connected to input ends of the plurality of DC-DC modules 101-3 through direct current buses, namely, Bus+ and Bus-, and output ends of the plurality of DC-DC modules 101-3 are connected to a plurality of input ends of the power distribution apparatus 103. The power distribution apparatus 103 is configured to distribute, to the charging interfaces 105, direct currents that are output by the DC-DC modules 101-3.

During actual application, the power distribution apparatus 103 includes a plurality of input ends, a plurality of output ends, and a plurality of switch components. The input ends of the power distribution apparatus 103 are configured to receive direct currents, the output ends of the power distribution apparatus 103 are connected to the charging interfaces, and the switch components are connected between the input ends and the output ends of the power distribution apparatus 103 to connect or disconnect current paths between the input ends and the output ends of the power distribution apparatus 103, so that a direct current that is output by the power conversion apparatus 101 can be distributed to the charging interfaces 105, to charge the electric vehicle.

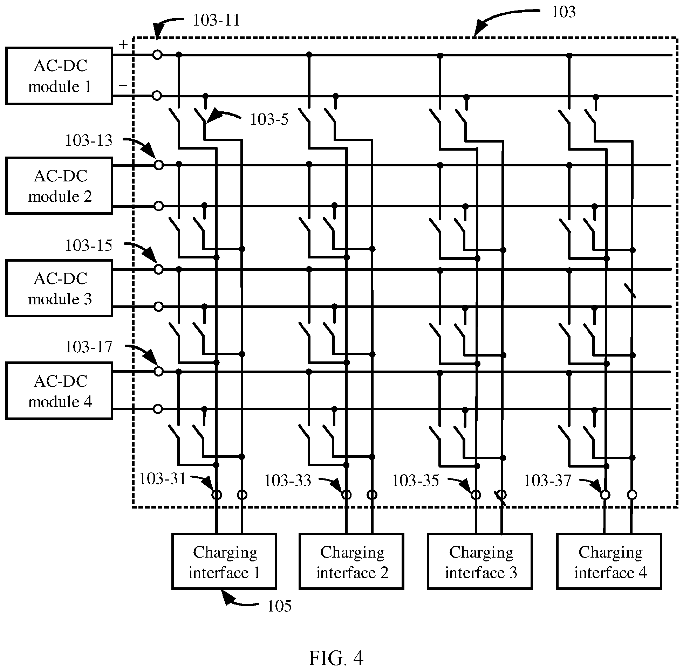

FIG. 4 is a schematic of a circuit connection of the power distribution apparatus 103 in FIG. 1. In FIG. 4, the power conversion apparatus 101 includes four AC-DC modules, and the power distribution apparatus 103 includes four groups of input ends 103-11, 103-13, 103-15, and 103-17, four groups of output ends 103-31, 103-33, 103-35, and 103-37, and a plurality of groups of switch components 103-5. Switch components 103-5 are connected between each group of input ends 103-1 and each group of output ends 103-3. It is assumed that rated output power of each AC-DC module is 60 kW. For example, a charging interface 1 is connected to an electric vehicle, and charging power required by the electric vehicle is 120 kW. The charging pile 10 may control switch components 103-5 connected between an AC-DC module 1 and the charging interface 1 and switch components 103-5 connected between an AC-DC module 2 and the charging interface 1 to be turned on, so that the charging interface 1 can output electric energy with power of 120 kW to charge the electric vehicle. Alternatively, the charging pile 10 may control the switch components 103-5 connected between the AC-DC module 2 and the charging interface 1 and switch components 103-5 connected between an AC-DC module 3 and the charging interface 1 to be turned on, so that the charging interface 1 can output electric energy with power of 120 kW to charge the electric vehicle. Similarly, the charging pile 10 may control, based on the charging power of the electric vehicle and the rated output power of the AC-DC module, switch components 103-5 to be turned on or off, so that the charging interface 105 outputs appropriate power to charge the electric vehicle.

It should be noted that each group of input ends of the power distribution apparatus 103 includes a positive input end and a negative input end, and each group of output ends includes a positive output end and a negative output end. When switch components 103-5 are connected between a group of input ends and a group of output ends, a switch needs to be connected between the positive input end and the positive output end, and a switch needs to be connected between the negative input end and the negative output end.

During specific use, some input ends of the power distribution apparatus 103 may alternatively be directly connected to some output ends without using switch components 103-5. This is not limited in this application.

In a possible implementation, a switch in a switch component 103-5 is a contactor. However, the contactor has problems such as high costs, a large volume, and difficult soldering and assembly with a printed circuit board PCB. In addition, extensive use of contactors results in a large quantity of signal control lines inside the power distribution apparatus 103. This is likely to cause a safety hazard, and reduces reliability of the power distribution apparatus 103.

In a possible implementation, a switch in a switch component 103-5 is a relay. Compared with a contactor, the relay has advantages such as a small volume and easy soldering and assembly with a PCB, but through-current density of the relay is usually small. Therefore, a form, specifications, and a pin layout of the relay need to be designed to satisfy requirements of a high-voltage and large-current use scenario.

In view of this, an embodiment of this application provides a relay. After being assembled with a PCB, the relay is applicable to a high-voltage and large-current use scenario.

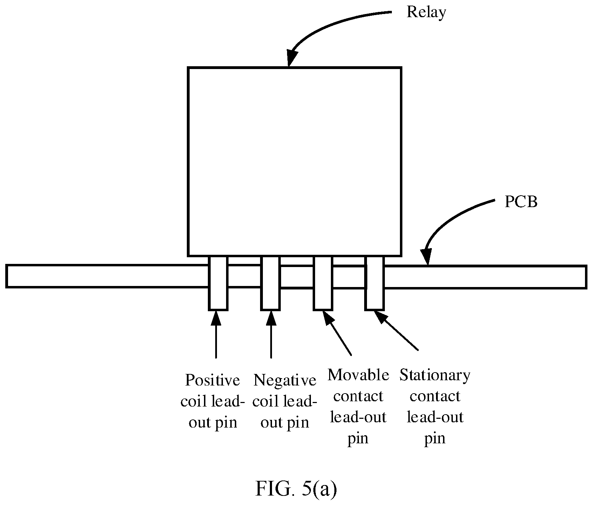

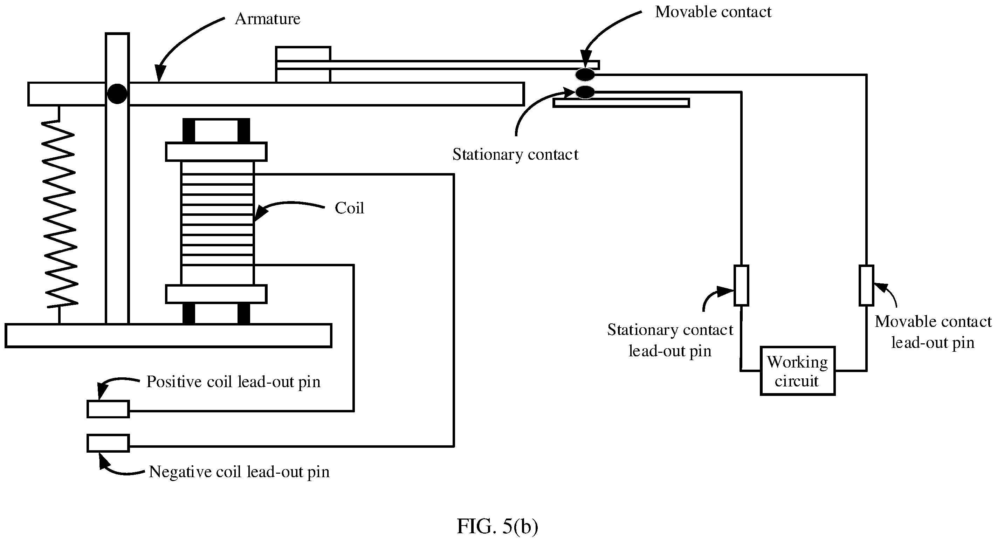

For better understanding of technical solutions of this application, a principle of the relay is first described. FIG. 5(a) is a diagram of a use scenario of a relay. FIG. 5(b) is a diagram of an internal principle of a relay. With reference to FIG. 5(a) and FIG. 5(b), a positive coil lead-out pin, a negative coil lead-out pin, a movable contact lead-out pin, and a stationary contact lead-out pin of the relay are connected to a PCB through soldering. The positive coil lead-out pin and the negative coil lead-out pin are configured to receive a current. The movable contact lead-out pin and the stationary contact lead-out pin are configured to connect to a working circuit (that is, a circuit whose connection or disconnection needs to be controlled) in the PCB. For example, a movable contact and a stationary contact are in a normally open state. When the positive coil lead-out pin and the negative coil lead-out pin do not receive a current, the movable contact and the stationary contact are in an unconnected state, and the working circuit is not connected in this case. After the positive coil lead-out pin and the negative coil lead-out pin receive a current, the current passes through a coil and a magnetic field is generated, to attract an armature to act, so that the movable contact and the stationary contact of the relay are closed, and the working circuit is connected. A state between the movable contact and the stationary contact of the relay can be controlled by controlling the coil to be energized or not to be energized, so that the relay can connect or disconnect the working circuit.

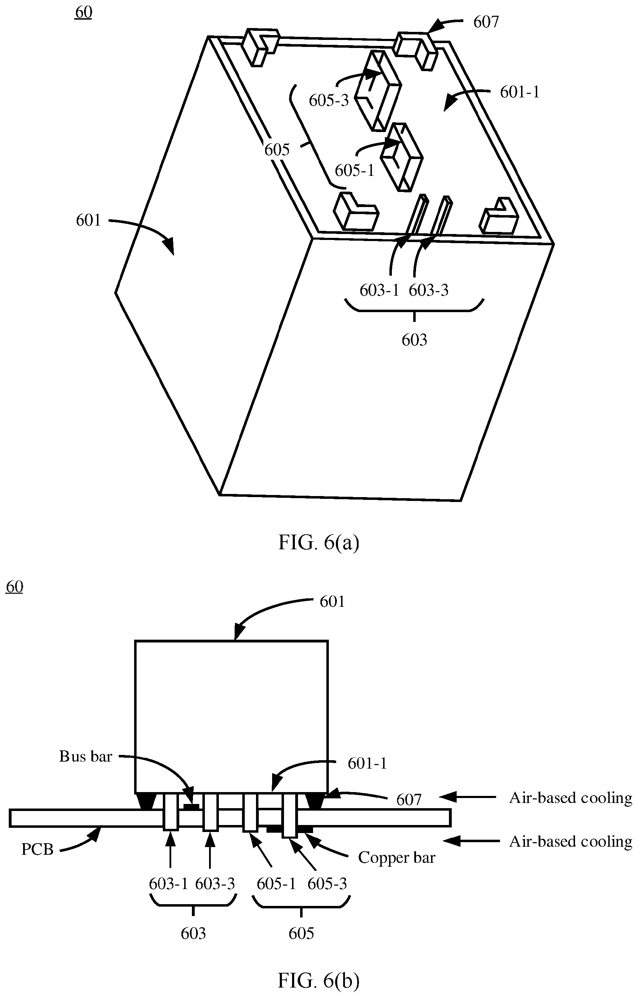

The following describes a relay provided in an embodiment of this application. FIG. 6(a) is a diagram of a structure of a relay according to an embodiment of this application. FIG. 6(b) is a diagram of a principle of soldering the relay in FIG. 6(a) to a PCB. Refer to FIG. 6(a) and FIG. 6(b). The relay 60 includes a housing 601, at least one group of main lead-out pin components 605, and at least one group of main contact components (not shown in the figure). Each group of main contact components is located inside the relay 60, that is, inside the housing 601. Each group of main contact components includes a movable contact and a stationary contact. Each group of main lead-out pin components 605 is located outside the relay 60, each group of main lead-out pin components 605 is connected to the main contact components, and each group of main lead-out pin components 605 is configured to connect to a circuit to control connection or disconnection of the circuit. Each group of main lead-out pin components 605 includes a long lead-out pin 605-3 and a short lead-out pin 605-1, and a length of the long lead-out pin 605-3 is greater than a length of the short lead-out pin 605-1.

Specifically, the relay 60 further includes coil lead-out pin components 603. The coil lead-out pin components 603 include a positive coil lead-out pin 603-1 and a negative coil lead-out pin 603-3. The positive coil lead-out pin 603-1 and the negative coil lead-out pin 603-3 are connected to a coil (not shown in the figure) in the relay 60.

In a possible implementation, a bottom wall 601-1 of the housing 601 includes an inner surface and an outer surface that are disposed opposite to each other. The inner surface faces the inside of the relay 60, the outer surface faces the outside of the relay 60, and the outer surface of the bottom wall 601-1 includes at least one protrusion 607. A length of each of the at least one protrusion 607 is less than a length of a lead-out pin in the main lead-out pin components 605 in a direction from the inner surface to the outer surface.

During specific disposing, a cross-sectional shape of the protrusion 607 may be a rectangle, a square, a circle, an "L" shape, a trapezoid, or the like, and a quantity of protrusions 607 may be 1, 2, 3, or the like. Shapes and a quantity of protrusions are not limited in this application.

Disposing positions of the coil lead-out pin components 603 and the main lead-out pin components 605 in FIG. 6(a) are merely examples. During specific use, the positions of the coil lead-out pin components 603 and the main lead-out pin components 605 may be flexibly set according to an actual use scenario. This is not limited in this application.

Refer to FIG. 6(b). The PCB includes a top surface facing the bottom wall 601-1 and a bottom surface disposed opposite to the top surface. The PCB includes a plurality of vias in a direction from the top surface to the bottom surface, and the coil lead-out pin components 603 and the main lead-out pin components 605 of the relay 60 are soldered to the PCB through the vias.

In a possible implementation, lengths of all protrusions 607 are the same in the direction from the inner surface to the outer surface of the bottom wall 601-1. All the protrusions 607 may be in contact with the top surface of the PCB, or all the protrusions 607 may be in contact with copper bars or bus bars disposed on the top surface of the PCB. In another possible implementation, lengths of some protrusions 607 are greater than lengths of other protrusions 607 in the direction from the inner surface to the outer surface of the bottom wall 601-1. Some protrusions 607 may be in contact with the top surface of the PCB, and other protrusions 607 may be in contact with copper bars or bus bars disposed on the top surface of the PCB. During specific implementation, the copper bar may be replaced with an aluminum bar. A material for transmitting a current on the PCB is not limited in embodiments of this application.

In a possible implementation, a surface of the protrusion 607 may further include a cutting line, and the protrusion 607 may be broken along the cutting line by using a tool such as a hand or diagonal pliers, to change a length of the protrusion 607. For example, the surface of the protrusion 607 may include at least one cutting line. When the surface of the protrusion 607 includes a plurality of cutting lines, a protrusion 607 of a different length may be obtained by breaking the protrusion 607 along a different cutting line, so that the relay 60 is flexibly applicable to a plurality of through-current network layouts of the PCB.

When a circuit is working, currents passing through the PCB and the main lead-out pin components 605 are large, and enormous heat is generated. The protrusion 607 is disposed between the top surface of the PCB and the bottom wall 601-1 of the housing 601, so that a gap between the bottom wall 601-1 and the top surface of the PCB can be enlarged. This can increase contact areas between air and both the top surface of the PCB and the main lead-out pin components 605 to facilitate heat dissipation, and further increase through-current density of the relay 60 and the PCB. In addition, after the gap between the bottom wall 601-1 and the top surface of the PCB is enlarged, a bus bar or a copper bar may be disposed on the top surface of the PCB, and the bus bar and the copper bar may further improve a through-current capability of the PCB.

In a possible implementation, as shown in FIG. 6(b), an air-based cooling manner may be used to dissipate heat from the top surface of the PCB, the bottom surface of the PCB, and the main lead-out pin components 605, to further improve heat dissipation capabilities of the PCB and the main lead-out pin components 605, and further improve the through-current capability of the PCB. In this implementation, to better use the gap to dissipate heat from the top surface of the PCB and the main lead-out pin components 605, the protrusion 607 does not block the main lead-out pin components 605 in an air flow direction. In other words, a projection of the protrusion 607 does not overlap projections of the main lead-out pin components 605 in the air flow direction.

In a possible implementation, a length of the protrusion 607 is 1 mm to 10 mm in the direction from the inner surface to the outer surface of the bottom wall 601-1. In this disposing manner, the gap between the top surface of the PCB and the bottom wall 601-1 of the housing 601 can satisfy a heat dissipation requirement, and a volume of the PCB assembled with the relay 60 is not excessively large, thereby facilitating miniaturization of an overall structure. When the length of the protrusion 607 is 3 mm to 6 mm, the PCB assembled with the relay 60 has a good heat dissipation capability and a small overall structure. During actual application, the length of the protrusion 607 may be flexibly set based on a size of the PCB and a size of the copper bar.

Still refer to FIG. 6(b). When the relay 60 is assembled with the PCB, the short lead-out pin 605-1 in the main lead-out pin components 605 is configured to connect to a through-current path on the top surface of the PCB or inside the PCB through the via on the PCB, and the long lead-out pin 605-3 in the main lead-out pin components 605 is configured to connect to a copper bar on the bottom surface of the PCB through the via on the PCB.

Because a copper bar has a specific thickness, and a lead-out pin needs to be soldered to the copper bar through a via, the lead-out pin needs to penetrate the copper bar for a specific distance to facilitate soldering. Therefore, the manner of disposing the long lead-out pin 605-3 in the main lead-out pin components 605 can facilitate soldering of the long lead-out pin 605-3 to the copper bar.

In a possible implementation, the bottom surface of the PCB includes a copper bar, the long lead-out pin 605-3 in the main lead-out pin components 605 passes through the via to be soldered to the copper bar on the bottom surface of the PCB, and the short lead-out pin 605-1 in the main lead-out pin components 605 passes through the via to be soldered to a through-current path (for example, a copper foil network) inside the PCB. In another possible implementation, both the top surface and the bottom surface of the PCB include a copper bar, the long lead-out pin 605-3 in the main lead-out pin components 605 passes through the via to be soldered to the copper bar on the bottom surface of the PCB, and the short lead-out pin 605-1 in the main lead-out pin components 605 passes through the via to be soldered to the copper bar on the top surface of the PCB.

Because lengths of the two lead-out pins in the main lead-out pin components 605 of the relay 60 provided in this embodiment of this application are different, the relay 60 is flexibly applicable to a solution in which a copper bar is disposed on the top surface of the PCB or a solution in which a copper bar is disposed on the bottom surface of the PCB. Because the copper bar has a strong through-current capability, the through-current capability of the PCB can be improved, and the through-current density of the PCB can be increased. In addition, because the copper bar has a large area and good heat conductivity and heat uniformity, when a lead-out pin is soldered to the copper bar, the copper bar can quickly disperse heat of a solder joint between the lead-out pin and the copper bar, to facilitate assembly of the lead-out pin with the PCB.

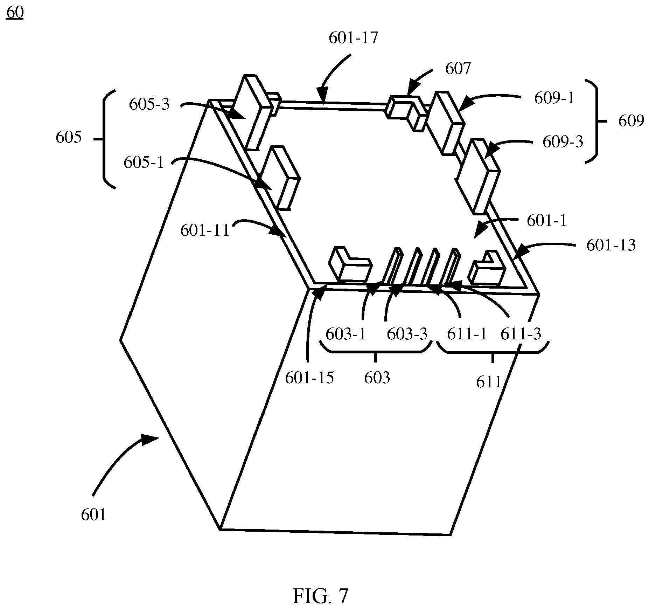

FIG. 7 is a diagram of another structure of a relay according to an embodiment of this application. A difference from FIG. 6(a) lies in that the relay shown in FIG. 7 includes two groups of main lead-out pin components: main lead-out pin components 605 and main lead-out pin components 609.

In a possible implementation, a cross-sectional area of each lead-out pin in the main lead-out pin components 605 and the main lead-out pin components 609 is 10 mm² to 30 mm². In this disposing manner, the main lead-out pin components 605 and the main lead-out pin components 609 can have strong through-current capabilities and good heat dissipation capabilities.

In a possible implementation, distances between lead-out pins in the main lead-out pin components 605 and the main lead-out pin components 609 are all 5 mm to 50 mm, so that distances between a short lead-out pin 605-1, a long lead-out pin 605-3, a short lead-out pin 609-1, and a long lead-out pin 609-3 satisfy a creepage distance requirement for basic insulation at 1000 VDC in GB/T 16935.1, GB/T 18487.1, IEC 60664-1, IEC 62477-1, UL 2202, and another relay industry standard. In this way, the relay 60 is applicable to most electric vehicle charging scenarios, and use safety of the relay 60 is improved.

In a possible implementation, when a movable contact and a stationary contact that are connected to the main lead-out pin components 605 are in an open state, and a movable contact and a stationary contact that are connected to the main lead-out pin components 609 are in an open state, an open distance between a movable contact and a stationary contact in each group is greater than or equal to 1.5 mm. In this way, a safety requirement can be satisfied, and use reliability of the relay 60 can be improved.

In a possible implementation, a bottom wall 601-1 of the relay 60 is in a quadrilateral shape, the bottom wall 601-1 includes a first edge 601-11 and a second edge 601-13 that are disposed opposite to each other and a third edge 601-15 and a fourth edge 601-17 that are disposed opposite to each other, and two long lead-out pins and two short lead-out pins in the two groups of main lead-out pin components 605 and 609 are arranged at intervals in a circumferential direction of the bottom wall 601-1. One long lead-out pin and one short lead-out pin in the two groups of main lead-out pin components 605 and 609 are arranged close to the first edge 601-11, the other long lead-out pin and the other short lead-out pin in the two groups of main lead-out pin components are arranged close to the second edge 601-13, and a projection of the one long lead-out pin does not overlap a projection of the other long lead-out pin in a direction from the first edge 601-11 to the second edge 601-13.

In a possible implementation, the main lead-out pin components 605 are arranged close to the first edge 601-11, and distances between the main lead-out pin components 605 and the first edge 601-11 are 2 mm to 25 mm. The main lead-out pin components 609 are arranged close to the second edge 601-13, and distances between the main lead-out pin components 609 and the second edge 601-13 are 2 mm to 25 mm. In this way, the main lead-out pin components 605 and the main lead-out pin components 609 can be distributed at edges of the bottom wall 601-1, to facilitate subsequent assembly with a PCB.

In another possible implementation, the long lead-out pin and the short lead-out pin that are arranged close to the first edge 601-11 are respectively from the main lead-out pin components 605 and the main lead-out pin components 609, and the long lead-out pin and the short lead-out pin that are arranged close to the second edge 601-13 are respectively from the main lead-out pin components 605 and the main lead-out pin components 609. In other words, a long lead-out pin and a short lead-out pin are paired in the direction from the first edge 601-11 to the second edge 601-13.

In a possible implementation, in a direction from the third edge 601-15 to the fourth edge 601-17, the long lead-out pin 605-3 and the short lead-out pin 605-1 in the main lead-out pin components 605 are disposed in parallel with the first edge 601-11, and the long lead-out pin 609-3 and the short lead-out pin 609-1 in the main lead-out pin components 609 are disposed in parallel with the second edge 601-13, so that the structure of the relay 60 can be regular. Still refer to FIG. 7. The two long lead-out pins and the two short lead-out pins in the two groups of main lead-out pin components 605 and 609 are arranged at intervals in the circumferential direction of the bottom wall 601-1, and a projection of the long lead-out pin 605-3 in the main lead-out pin components 605 does not overlap a projection of the long lead-out pin 609-3 in the main lead-out pin components 609 in the direction from the first edge 601-11 to the second edge 601-13. This disposing manner can resolve a problem that a plurality of current transmission paths in the PCB need to avoid each other, facilitate routing on the PCB, improve utilization of the PCB, and reduce a size of the PCB.

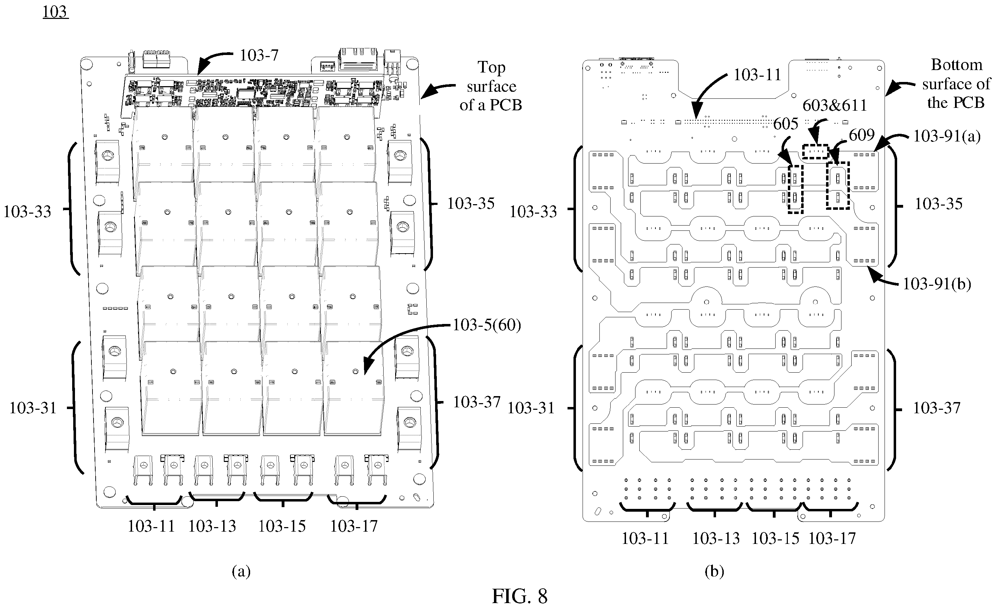

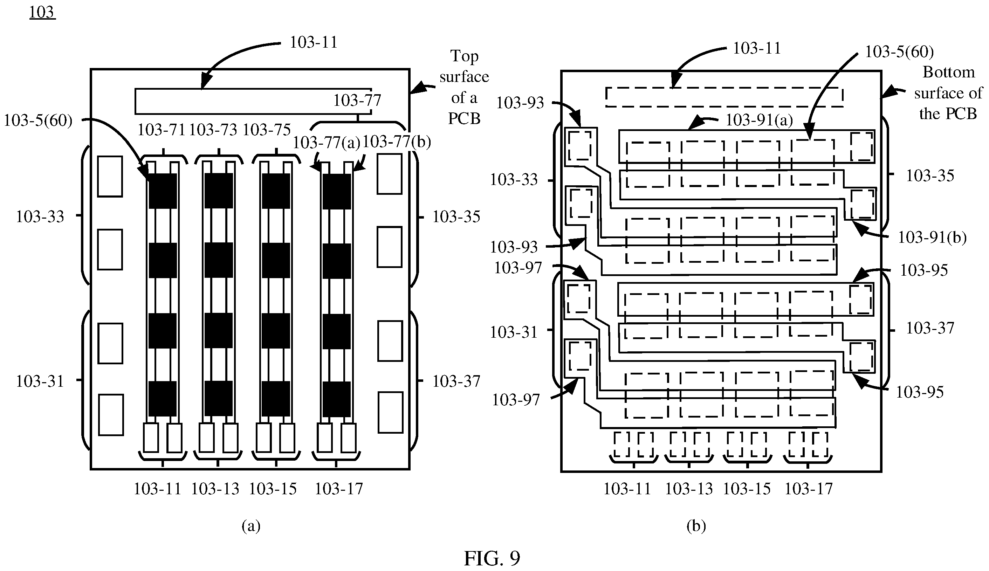

Specifically, an architecture of the power distribution apparatus shown in FIG. 4 is used as an example to describe how a pin layout of the relay 60 provided in embodiments of this application can resolve a problem that a plurality of current transmission paths need to avoid each other. Refer to FIG. 8 and FIG. 9. FIG. 8 is a diagram of a structure of the power distribution apparatus in FIG. 4 formed by assembling relays 60 with a PCB. FIG. 9 is a diagram of a principle of connection between the relays 60 and the PCB in FIG. 8. Specifically, (a) in FIG. 8 is a diagram of a structure of assembly of the relays 60 with a top surface of the PCB, (b) in FIG. 8 is a diagram of a structure of assembly of the relays 60 with a bottom surface of the PCB, (a) in FIG. 9 is a diagram of a circuit principle of connection between the relays 60 and the top surface of the PCB, and (b) in FIG. 9 is a diagram of a circuit principle of connection between the relays 60 and the bottom surface of the PCB. In this embodiment, each relay 60 uses the structure shown in FIG. 7. As shown in FIG. 8, the power distribution apparatus 103 includes a PCB, four groups of input terminals 103-11, 103-13, 103-15, and 103-17, four groups of output terminals 103-31, 103-33, 103-35, and 103-37, and 16 relays 60. To be specific, one relay 60 is connected between each group of input terminals and each group of output terminals. Vias are provided between a top surface of the PCB and a bottom surface of the PCB. Main lead-out pin components 605 and main lead-out pin components 609 of the relays 60 are soldered to the PCB through the vias, to be fastened to the PCB.

Refer to (a) in FIG. 9. The top surface or an inner layer of the PCB includes four groups of current input paths (for example, current transmission paths made of copper foil) 103-71, 103-73, 103-75, and 103-77, and the four groups of current input paths 103-71, 103-73, 103-75, and 103-77 are configured to transmit input currents. The bottom surface of the PCB includes four groups of current output paths (for example, copper bars or aluminum bars) 103-91, 103-93, 103-95, and 103-97, the four groups of current output paths are configured to transmit output currents, and each group of current input paths is connected to each group of current output paths through the relay 60.

In other words, the plurality of groups of current input paths are connected to the plurality of groups of input terminals in one-to-one correspondence, the plurality of groups of current output paths are connected to the plurality of groups of output terminals in one-to-one correspondence, and each group of current input paths is connected to each group of current output paths through the main lead-out pin components 605 and the main lead-out pin components 609 of the relay 60. The input terminals 103-11 are used as an example. The input terminals 103-11 are connected to the current input paths 103-71, and the current input paths 103-71 are connected to the four groups of current output paths 103-91, 103-93, 103-95, and 103-97 through four relays 60 respectively. In this case, currents input from the input terminals 103-11 can be transmitted to a corresponding output end provided that movable contacts and stationary contacts connected to two groups of main lead-out pin components of one of the four relays are controlled to be closed.

It should be noted that, each group of input terminals includes a positive input terminal and a negative input terminal; each group of current input paths includes two current input paths, that is, a positive current input path and a negative current input path that are configured to receive a positive current and a negative current respectively; each group of current output paths includes two current output paths, that is, a positive current output path and a negative current output path that are configured to output a positive current and a negative current respectively; and each relay 60 includes two groups of main lead-out pin components, one group of main lead-out pin components is configured to transmit a positive current, and the other group of main lead-out pin components is configured to transmit a negative current.

In a possible implementation, the plurality of groups of current input paths may alternatively be disposed only on the top surface of the PCB, and are not disposed inside the PCB.

Refer to FIG. 7, (b) in FIG. 8, (a) in FIG. 9, and (b) in FIG. 9. The relay 60 connected between the current input paths 103-77 and the current output paths 103-91 is used as an example. The main lead-out pin components 605 of the relay 60 are configured to transmit a positive current in the current input paths 103-77, and the main lead-out pin components 609 are configured to transmit a negative current in the current input paths 103-77. The current input paths 103-77 include a positive current input path 103-77(a) and a negative current input path 103-77(b), and the current output paths 103-91 include a positive current output path 103-91(a) and a negative current output path 103-91(b). It can be learned from (b) in FIG. 8 that, a long lead-out pin 605-3 in the main lead-out pin components 605 is connected to the positive current output path 103-91(a) through the via, and a short lead-out pin 605-1 in the main lead-out pin components 605 is connected to the positive current input path 103 -77(a) through the via. In other words, the short lead-out pin 605-1 in the main lead-out pin components 605 is configured to receive a positive current, and the long lead-out pin 605-3 in the main lead-out pin components 605 is configured to output the positive current. Similarly, a long lead-out pin 609-3 in the main lead-out pin components 609 is connected to the negative current output path 103-91(b) through the via, and a short lead-out pin 609-1 in the main lead-out pin components 609 is connected to the negative current input path 103-77(b) through the via. In other words, the short lead-out pin 609-1 in the main lead-out pin components 609 is configured to receive a negative current, and the long lead-out pin 609-3 in the main lead-out pin components 609 is configured to output the negative current.

Still refer to FIG. 7. Because a projection of the long lead-out pin 605-3 in the main lead-out pin components 605 does not overlap a projection of the long lead-out pin 609-3 in the main lead-out pin components 609 in a direction from a first edge 601-11 to a second edge 601-13, the positive current output path 103-91(a) and the negative current output path 103-91(b) in the current output paths 103-91 may be disposed independently of each other, to prevent a problem that the two paths need to avoid each other due to crossing. This facilitates a regular layout of the PCB, and improves utilization of the PCB. An arrangement manner of another relay 60 is the same as that of the relay 60. Details are not described herein again.

Still refer to FIG. 7. In a possible implementation, in a direction from a third edge 601-15 to a fourth edge 601-17, a projection of one long lead-out pin overlaps a projection of one short lead-out pin, and a projection of the other long lead-out pin overlaps a projection of the other short lead-out pin. This can make the structure of the relay 60 regular, reduce a volume of the relay 60, facilitate a regular layout of the PCB, and improve utilization of the PCB.

In a possible implementation, projections of a long lead-out pin and a short lead-out pin that are arranged close to the first edge 601-11 in the direction from the first edge 601-11 to the second edge 601-13 overlap, and projections of a long lead-out pin and a short lead-out pin that are arranged close to the second edge 601-13 in the direction from the first edge 601-11 to the second edge 601-13 overlap. In this way, the structure of the relay 60 can be regular, a volume of the relay 60 can be reduced, a plurality of current input paths on the PCB can be disposed independently of each other and in parallel, and a plurality of current output paths on the PCB can be disposed independently of each other and in parallel. This facilitates an overall layout of the PCB, and improves utilization of the PCB.

In a possible implementation, a first insulation partition 617-1 is disposed between the long lead-out pin and the short lead-out pin that are arranged close to the first edge 601-11 in the direction from the first edge 601-11 to the second edge 601-13, and a second insulation partition 617-3 is disposed between the long lead-out pin and the short lead-out pin that are arranged close to the second edge 601-13 in the direction from the first edge 601-11 to the second edge 601-13. In other words, an insulation partition is disposed between two close lead-out pins, and the insulation partition can increase a creepage distance between the two close lead-out pins, so that use safety of the relay 60 can be further improved. In a possible implementation, the first insulation partition 617-1 may extend out of the first edge 601-11, to prevent the two lead-out pins close to the first edge 601-11 from being short-circuited along the first edge 601-11 through condensation, and further improve isolation effect of the first insulation partition 617-1. Similarly, the second insulation partition 617-3 may extend out of the second edge 601-13.

In a possible implementation, in a direction from an inner surface of a bottom wall 601-1 to an outer surface of the bottom wall 601-1, a length of the first insulation partition 617-1 is greater than or equal to a length of each of the long lead-out pin and the short lead-out pin that are arranged close to the first edge 601-11, and a length of the second insulation partition 617-3 is greater than or equal to a length of each of the long lead-out pin and the short lead-out pin that are arranged close to the second edge 601-13. In this disposing manner, when the relay 60 is assembled with the PCB, holes may be provided at positions that are on the PCB and that correspond to the first insulation partition 617-1 and the second insulation partition 617-3. The holes are configured to accommodate the first insulation partition 617-1 and the second insulation partition 617-3, to facilitate assembly of the relay 60 with the PCB.

In another possible manner, the length of the first insulation partition 617-1 and the length of the second insulation partition 617-3 are equal to a length of a protrusion 607 in the direction from the inner surface of the bottom wall 601 - 1 to the outer surface of the bottom wall 601-1. When the relay 60 is assembled with the PCB, both the first insulation partition 617-1 and the second insulation partition 617-3 abut against the top surface of the PCB. In this way, no hole needs to be provided on the PCB, and an assembly process is simplified.

In a possible implementation, there may be a plurality of first insulation partitions 617-1 and a plurality of second insulation partitions 617-3, the plurality of first insulation partitions 607-1 are spaced apart, and the plurality of second insulation partitions 617-3 are spaced apart. A plurality of insulation partitions spaced apart can further increase a creepage distance between two close lead-out pins, and further improve use reliability of the relay 60.

During specific disposing, a quantity of insulation partitions may be flexibly set according to a use scenario of the relay 60, so that the relay 60 can satisfy safety requirements in different scenarios.

In a possible implementation, a gap exists between every two adjacent insulation partitions, and an on-board insulation partition is disposed at a position that is on the PCB and that corresponds to the gap. When the relay 60 is assembled with the PCB, the on-board insulation partition on the PCB is inserted into the gap, and abuts against the bottom wall 601-1 of the relay 60. Generally, a volume of a relay is small, and a quantity of insulation partitions that can be disposed between two close lead-out pins is limited. In this disposing manner, a quantity of insulation partitions disposed on the relay 60 can be reduced, and use reliability of the relay 60 is not degraded.

In a possible implementation, a first groove is provided between the long lead-out pin and the short lead-out pin that are arranged close to the first edge 601-11 in the direction from the first edge 601-11 to the second edge 601-13, a second groove is provided between the long lead-out pin and the short lead-out pin that are arranged close to the second edge 601-13 in the direction from the first edge 601-11 to the second edge 601-13, and the first groove and the second groove are configured to accommodate an insulation partition.

In a possible implementation, the first groove and the second groove are provided independently of each other. In another possible implementation, the first groove and the second groove communicate with each other.

When the relay 60 is assembled with the PCB, holes may be provided at positions that are on the PCB and that correspond to the first groove and the second groove, and an insulation partition is inserted into a corresponding groove through the hole from the bottom surface of the PCB. In this way, the insulation partition is disposed between two close lead-out pins.

In a possible implementation, the two groups of main lead-out pin components are connected to two groups of main contact components respectively, a long lead-out pin in each group of main lead-out pin components is connected to one of a movable contact and a stationary contact in corresponding main contact components, and a short lead-out pin in each group of main lead-out pin components is connected to the other of the movable contact and the stationary contact in the corresponding main contact components.

In a possible implementation, the two groups of main contact components are driven by one electromagnetic system. In other words, an open/closed state of the main contact components connected to the main lead-out pin components 605 and an open/closed state of the main contact components connected to the main lead-out pin components 609 are driven by one coil.

Refer to FIG. 4. Each group of input ends 103-1 of the power distribution apparatus 103 includes a positive input end and a negative input end, and each group of output ends 103-3 includes a positive output end and a negative output end. When switches are connected between the input ends 103-1 and the output ends 103-3, a switch is connected between the positive input end and the positive output end, and a switch is connected between the negative input end and the negative output end. According to the relay 60 provided in this embodiment of this application, the two groups of main lead-out pin components are connected between the positive input end and the positive output end and between the negative input end and the negative output end respectively, and only one coil is required to drive the two groups of main contact components, so that an area of the PCB occupied by the relay 60 can be reduced, and control logic of the relay 60 can be simplified.

A principle of assembling the main lead-out pin components 609 with the PCB is the same as a principle of assembling the main lead-out pin components 605 with the PCB. Details are not described herein again.

Still refer to FIG. 7. In a possible implementation, the relay 60 further includes a group of coil lead-out pin components 603. The group of coil lead-out pin components 603 is connected to a coil, and is soldered to the PCB through vias of the PCB. The coil lead-out pin components 603 are arranged close to the third edge 601-15, and projections of the coil lead-out pin components 603 do not overlap projections of the main lead-out pin components 605 and the main lead-out pin components 609 in the direction from the third edge 601-15 to the fourth edge 601-17. In this way, an area of the bottom wall 601-1 of the relay 60 can be fully used, a volume of the relay 60 can be reduced, and when the coil lead-out pin components 603 are connected to the PCB, connection between the PCB and both the main lead-out pin components 605 and the main lead-out pin components 609 is not affected. This facilitates assembly of the relay 60 with the PCB.

Refer to (b) in FIG. 8 and (a) in FIG. 9. Because the projections of the coil lead-out pin components 603 do not overlap the projections of the main lead-out pin components 605 and the main lead-out pin components 609 in the direction from the third edge 601-15 to the fourth edge 601-17, when the coil lead-out pin components 603 are connected to the PCB through the vias, there is no need for a current input path to avoid the vias configured to connect to the coil lead-out pin components 603. This facilitates routing on the PCB, and improves utilization of the PCB.

Still refer to FIG. 7. In a possible implementation, the relay 60 further includes auxiliary contact lead-out pin components 611 and auxiliary contact components (not shown in the figure). The auxiliary contact lead-out pin components 611 are configured to indicate an open/closed state between a movable contact and a stationary contact that are connected to each group of main lead-out pin components. Specifically, the auxiliary contact lead-out pin components 611 include an auxiliary movable contact lead-out pin 611-1 and an auxiliary stationary contact lead-out pin 611-3, the auxiliary movable contact lead-out pin 611-1 is connected to an auxiliary movable contact in the auxiliary contact components, and the auxiliary stationary contact lead-out pin 611-3 is connected to an auxiliary stationary contact in the auxiliary contact components. The auxiliary movable contact and the auxiliary stationary contact are mechanically linked with the foregoing two groups of movable contacts and stationary contacts, so that the auxiliary movable contact and the auxiliary stationary contact can act simultaneously with the two groups of movable contacts and stationary contacts.

In a possible implementation, the auxiliary movable contact and the auxiliary stationary contact are in a normally open state. When the coil is not energized, a movable contact and a stationary contact that are connected to the main lead-out pin components 605 do not act relative to each other (do not change from an open state to a closed state), and a movable contact and a stationary contact that are connected to the main lead-out pin components 609 do not act relative to each other. In this case, the auxiliary movable contact and the auxiliary stationary contact do not act relative to each other. In other words, the auxiliary movable contact and the auxiliary stationary contact are still in the open state.

After the coil is energized, when at least one pair of a movable contact and a stationary contact of the movable contact and the stationary contact that are connected to the main lead-out pin components 605 and the movable contact and the stationary contact that are connected to the main lead-out pin components 609 act relative to each other (change from an open state to a closed state), the auxiliary movable contact and the auxiliary stationary contact act relative to each other. In other words, the auxiliary movable contact and the auxiliary stationary contact change to a closed state. When the coil changes from being energized to not being energized, in a normal state, the movable contacts and the stationary contacts in the two groups of main contact components act relative to each other (change from a closed state to an open state). In this case, the auxiliary movable contact and the auxiliary stationary contact are driven to change from the closed state to an open state. If the movable contact and the stationary contact in one of the two groups of main contact components are adhered and cannot act relative to each other, and only the movable contact and the stationary contact inthe other group of main contact components act relative to each other, the auxiliary movable contact and the auxiliary stationary contact do not act relative to each other and are still in the closed state.

In other words, as long as it is detected that the auxiliary movable contact and the auxiliary stationary contact are in a closed state, it can be determined that a movable contact and a stationary contact that are connected to at least one of the two groups of main lead-out pin components of the relay 60 are in a closed state. In this case, another relay 60 connected to a same input line as the relay 60 (the another relay 60 and the relay 60 receive direct currents that are output by a same power conversion module) may be controlled to be in an off state. In this way, when the power distribution apparatus assembled by using the plurality of relays 60 is connected to two electric vehicles at the same time, a short circuit between positive electrodes of the two vehicles or a short circuit between negative electrodes of the two vehicles can be prevented, so that use safety of the power distribution apparatus can be improved, and use safety of a charging pile is further improved.

During specific implementation, the auxiliary contact lead-out pin components 611 are connected to a detection circuit through the PCB, and a controller determines an open/closed state between the auxiliary movable contact and the auxiliary stationary contact based on an output signal of the detection circuit. For example, when the coil changes from being energized to not being energized, that is, when the controller controls the movable contacts and the stationary contacts in the main contact components to change from a connected state to an open state, if a movable contact and a stationary contact that are connected to at least one of the two groups of main lead-out pin components are adhered, the auxiliary movable contact and the auxiliary stationary contact do not act relative to each other and are still in a closed state. In this case, the controller determines, based on a state of the auxiliary contact components, that main contact components are adhered and are in a faulty state.

In another possible implementation, the auxiliary movable contact and the auxiliary stationary contact are in a normally closed state. When the coil is not energized, that is, when the movable contact and the stationary contact in each group of main contact components are in an open state, the auxiliary movable contact and the auxiliary stationary contact are in the closed state.

After the coil is energized, when a movable contact and a stationary contact in at least one of the two groups of main contact components act relative to each other and change from an open state to a closed state, the auxiliary movable contact and the auxiliary stationary contact act relative to each other and change from the closed state to an open state.

When the coil changes from being energized to not being energized, in a normal state, the movable contacts and the stationary contacts in the two groups of main contact components act relative to each other (change from a closed state to an open state). In this case, the auxiliary movable contact and the auxiliary stationary contact are driven to change from the open state to a closed state. If the movable contact and the stationary contact in one of the two groups of main contact components are adhered and cannot act relative to each other, and only the movable contact and the stationary contact in the other group of main contact components act relative to each other, the auxiliary movable contact and the auxiliary stationary contact are still in the open state.

In other words, as long as it is detected that the auxiliary movable contact and the auxiliary stationary contact are in an open state, it can be determined that a movable contact and a stationary contact that are connected to at least one of the two groups of main lead-out pin components of the relay 60 are in a closed state. In this case, another relay 60 connected to a same input line as the relay 60 may be controlled to be in an off state. In this way, when the power distribution apparatus assembled by using the plurality of relays 60 is connected to two electric vehicles at the same time, a short circuit between positive electrodes of the two vehicles or a short circuit between negative electrodes of the two vehicles can be prevented, so that use safety of the power distribution apparatus can be improved, and use safety of a charging pile is further improved.

During specific implementation, the auxiliary contact lead-out pin components 611 are connected to a detection circuit through the PCB, and a controller determines an open/closed state between the auxiliary movable contact and the auxiliary stationary contact based on an output signal of the detection circuit, to determine a state of the main lead-out pin components. For example, when the coil changes from being energized to not being energized, that is, when the controller controls the movable contacts and the stationary contacts in the main contact components to change from a closed state to an open state, if a movable contact and a stationary contact that are connected to at least one of the two groups of main lead-out pin components are adhered, the auxiliary movable contact and the auxiliary stationary contact are still in an open state. In this case, the controller determines that the auxiliary movable contact and the auxiliary stationary contact do not change from the open state to a closed state, and further determines that the relay 60 is faulty.

In a possible implementation, the auxiliary contact lead-out pin components 611 are arranged close to the third edge 601-15, and projections of the auxiliary contact lead-out pin components 611 do not overlap projections of the main lead-out pin components 605 and the main lead-out pin components 609 in the direction from the third edge 601-15 to the fourth edge 601-17. In this way, an area of the bottom wall 601-1 of the relay 60 can be fully used, a volume of the relay 60 can be reduced, and when the auxiliary contact lead-out pin components 611 are connected to the PCB, connection between the PCB and both the main lead-out pin components 605 and the main lead-out pin components 609 is not affected. This facilitates assembly of the relay 60 with the PCB.

Specifically, with reference to (b) in FIG. 8 and (a) in FIG. 9, because the projections of the auxiliary contact lead-out pin components 611 do not overlap the projections of the main lead-out pin components 605 and the main lead-out pin components 609 in the direction from the third edge 601-15 to the fourth edge 601-17, when the auxiliary contact lead-out pin components 611 are connected to the PCB through vias, there is no need for a current input path to avoid the vias configured to connect to the auxiliary contact lead-out pin components 611. This facilitates routing on the PCB, and improves utilization of the PCB.

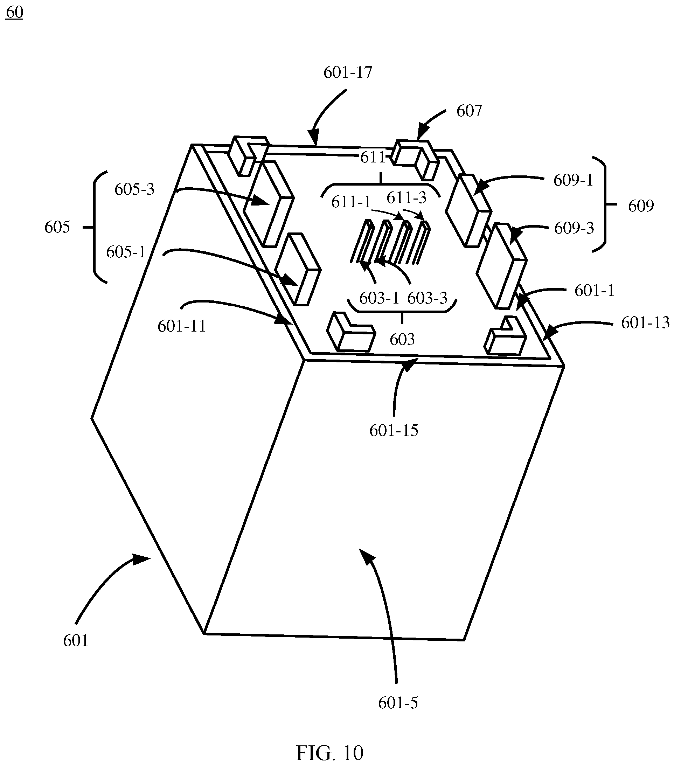

FIG. 10 is a diagram of still another structure of a relay according to an embodiment of this application. A difference from FIG. 7 lies in that coil lead-out pin components 603 and auxiliary contact lead-out pin components 611 may alternatively be disposed in a center of a bottom wall 601-1 of the relay 60. In this way, an area of the bottom wall 601-1 of the relay 60 can also be fully used, and a volume of the relay 60 can be reduced.

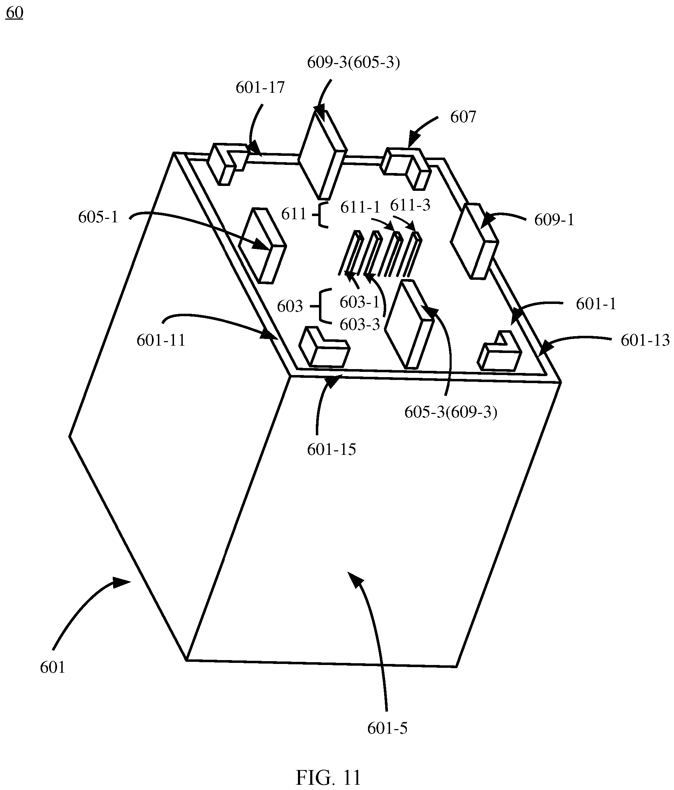

FIG. 11 is a diagram of still another structure of a relay according to an embodiment of this application. A difference from FIG. 10 lies in that two short lead-out pins in two groups of main lead-out pin components 605 and 609 are disposed close to a first edge 601-11 and a second edge 601-13 respectively, and two long lead-out pins in the two groups of main lead-out pin components 605 and 609 are disposed close to a third edge 601-15 and a fourth edge 601-17 respectively.

In a possible implementation, projections of the two short lead-out pins in the two groups of main lead-out pin components 605 and 609 overlap in a direction from the first edge 601-11 to the second edge 601-13, and projections of the two long lead-out pins in the two groups of main lead-out pin components 605 and 609 overlap in a direction from third edge 601-15 to the fourth edge 601-17. In this way, a lead-out pin layout of the relay 60 can be regular.

In a possible implementation, with reference to FIG. 11, the short lead-out pin 605-1 in the main lead-out pin components 605 is disposed close to the first edge 601-11, the short lead-out pin 609-1 in the main lead-out pin components 609 is disposed close to the second edge 601-13, the long lead-out pin 605-3 in the main lead-out pin components 605 is disposed close to the third edge 601-15, and the long lead-out pin 609-3 in the main lead-out pin components 609 is disposed close to the fourth edge 601-17.

In another possible disposing manner, the short lead-out pin 605-1 in the main lead-out pin components 605 is disposed close to the first edge 601-11, the short lead-out pin 609-1 in the main lead-out pin components 609 is disposed close to the second edge 601-13, the long lead-out pin 605-3 in the main lead-out pin components 605 is disposed close to the fourth edge 601-17, and the long lead-out pin 609-3 in the main lead-out pin components 609 is disposed close to the third edge 601-15.

In other words, in this implementation, in a circumferential direction of a bottom wall 601-1, the two long lead-out pins and the two short lead-out pins are disposed along the four edges respectively, and the two long lead-out pins and the two short lead-out pins are spaced apart. In this disposing manner, when the PCB includes a plurality of current transmission paths, a problem that the plurality of current transmission paths need to avoid each other can be resolved. This facilitates routing on the PCB, improves utilization of the PCB, and reduces a size of the PCB. A specific principle is the same as the analyzed principle of the arrangement of the lead-out pins in FIG. 7. Details are not described herein again.

When a relay 60 is working, voltages on main lead-out pin components 605 and main lead-out pin components 609 are far greater than voltages on coil lead-out pin components 603 and auxiliary contact lead-out pin components 611. To satisfy a safety requirement of a high-voltage lead-out pin and a low-voltage lead-out pin, in a possible implementation, distances between the main lead-out pin components 605 and the coil lead-out pin components 603 and distances between the main lead-out pin components 605 and the auxiliary contact lead-out pin components 611 are all 10 mm to 60 mm, and similarly, distances between the main lead-out pin components 609 and the coil lead-out pin components 603 and distances between the main lead-out pin components 609 and the auxiliary contact lead-out pin components 611 are all 10 mm to 60 mm.

Refer to FIG. 7 and FIG. 8. In a possible implementation, the power distribution apparatus 103 further includes a controller 103-7. The controller 103-7 is connected to the coil lead-out pin components 603 of the relay 60 through the PCB, and the controller 103-7 is configured to control an open/closed state between the movable contact and the stationary contact that are connected to the main lead-out pin components.

In a possible implementation, the controller 103-7 is further connected to the auxiliary contact lead-out pin components 611, and is configured to detect, by using the auxiliary contact lead-out pin components 611, an open/closed state between the movable contact and the stationary contact that are connected to the main lead-out pin components.

In a possible implementation, the power distribution apparatus 103 further includes a communication terminal. The communication terminal is configured to connect to a controller of a charging pile and the controller 103-7 of the power distribution apparatus 103. The controller of the charging pile is configured to send a control signal to the communication terminal based on charging information of a vehicle. The controller 103-7 of the power distribution apparatus 103 is configured to control, based on the control signal, an open/closed state between the movable contact and the stationary contact that are connected to the main lead-out pin components, so as to control a magnitude of a current for charging the electric vehicle.

Refer to FIG. 7, FIG. 10, and FIG. 11. Each lead-out pin in each group of main lead-out pin components includes a first side surface and a second side surface that are disposed opposite to each other and a third side surface and a fourth side surface that are disposed opposite to each other. A sum of areas of the first side surface and the second side surface is less than a sum of areas of the third side surface and the fourth side surface. A projection of a protrusion 607 does not overlap a projection of each lead-out pin in each group of main lead-out pin components in a direction from the first side surface to the second side surface.

In a possible implementation, the power distribution apparatus 103 further includes a housing. To better dissipate heat from the relay 60 and the PCB, an air intake vent and an air exhaust vent may be provided on the housing, and heat is dissipated from the relay 60 and the PCB in an air-based cooling manner.

In a possible manner, the housing includes a first side wall and a second side wall that are disposed opposite to each other in the direction from the first side surface to the second side surface. The air intake vent and the air exhaust vent may be disposed on the first side wall and the second side wall respectively. In this disposing manner, a projection of the protrusion 607 does not overlap a projection of each lead-out pin in each group of main lead-out pin components in an air flow direction. In other words, the protrusion 607 does not block the main lead-out pin components 605 and the main lead-out pin components 609 in the air flow direction. In this way, a contact area between air and each lead-out pin in the main lead-out pin components can be large, so that efficiency in dissipating heat from the main lead-out pin components 605 and the main lead-out pin components 609 is improved.

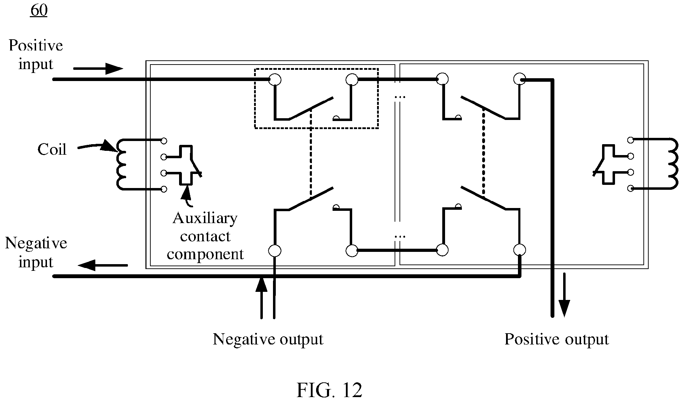

FIG. 12 is a diagram of another principle of a relay according to an embodiment of this application. A difference from the foregoing relay lies in that the relay 60 includes two series units, each series unit includes M groups of main contact components, and the two series units are in one-to-one correspondence with two groups of main lead-out pin components, where M is an integer greater than or equal to 2. The M groups of main contact components are sequentially connected in series, one contact in a 1^{st} group of main contact components is connected to a short lead-out pin in the main lead-out pin components, and one contact in an M^{th} group of main contact components is connected to a long lead-out pin in the main lead-out pin components.

In other words, M groups of main contact components are connected in series between a long lead-out pin and a short lead-out pin in each group of main lead-out pin components. Only when a movable contact and a stationary contact in each group of main contact components are closed can a current pass through the long lead-out pin and the short lead-out pin.

In the manner of connecting a plurality of groups of main contact components in series, a distance between the long lead-out pin and the short lead-out pin can be increased, so that a problem of an insufficient safety distance between the long lead-out pin and the short lead-out pin is resolved, and use reliability of the relay is improved.

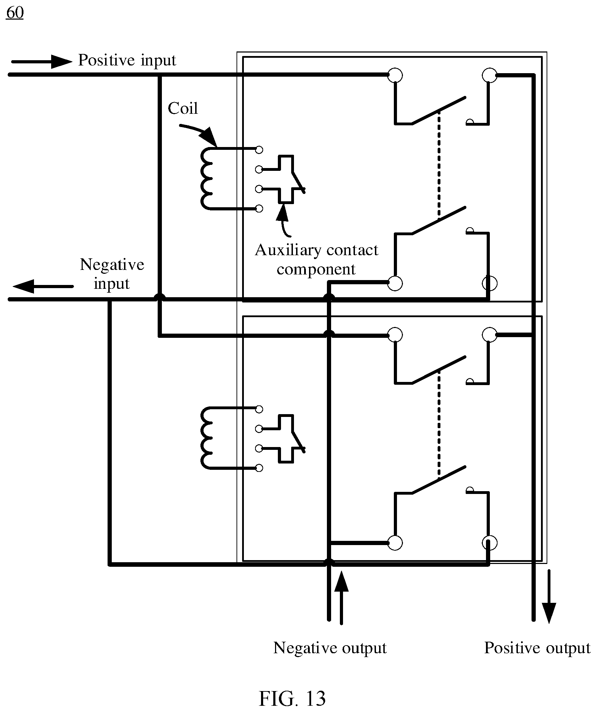

FIG. 13 is a diagram of still another principle of a relay according to an embodiment of this application. A difference from the foregoing relay lies in that the relay 60 includes two parallel units, each parallel unit includes M groups of main contact components, and the two parallel units are in one-to-one correspondence with two groups of main lead-out pin components, where M is an integer greater than or equal to 2. The M groups of main contact components are connected in parallel, M contacts in the M groups of main contact components are connected to a short lead-out pin in the main lead-out pin components, and other M contacts in the M groups of main contact components are connected to a long lead-out pin in the main lead-out pin components.

In other words, M groups of main contact components are connected in parallel between a short lead-out pin and a long lead-out pin in each group of main lead-out pin components. When a current passing through the long lead-out pin and the short lead-out pin is large, a line generates enormous heat. If a movable contact and a stationary contact act relative to each other, the movable contact and the stationary contact are adhered due to excessively high temperature, and consequently the relay 60 cannot work normally. In the manner of connecting a plurality of groups of main contact components in parallel, a current passing through each group of main contact components can be reduced, so that a probability of adhesion between the movable contact and the stationary contact is reduced, and use reliability of the relay 60 is improved.

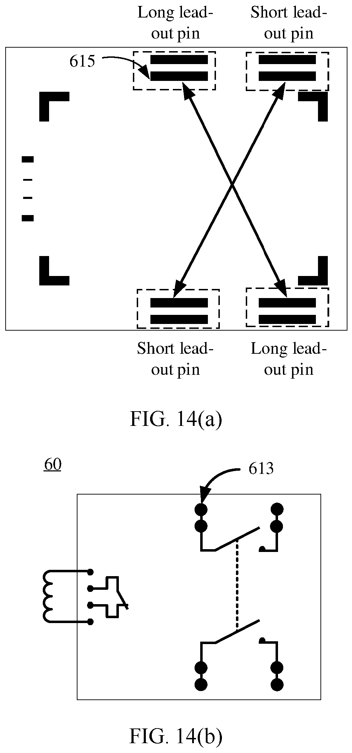

FIG. 14(a) is a cross-sectional view of a relay according to an embodiment of this application. FIG. 14(b) is a diagram of a principle of the relay shown in FIG. 14(a). Refer to FIG. 14(a) and FIG. 14(b). A difference from the foregoing relay lies in that at least one movable contact or at least one stationary contact in each group of main contact components includes a plurality of split contacts 613, the plurality of split contacts 613 are connected in series, at least one long lead-out pin or at least one short lead-out pin in each group of main lead-out pin components includes a plurality of split lead-out pins 615, the plurality of split lead-out pins are connected to the plurality of split contacts in one-to-one correspondence, and the plurality of split lead-out pins are disposed in parallel with each other.

The design of split lead-out pins can increase a through-current cross-sectional area of the main lead-out pin components, and correspondingly increase a heat dissipation area of the main lead-out pin components, so that through-current density of the relay 60 can be improved.

Based on this, an embodiment of this application further provides a power distribution apparatus. Refer to FIG. 8. The power distribution apparatus includes a PCB and the relays 60 described above. Vias are provided between a top surface and a bottom surface of the PCB, and the relays are connected to the PCB through the vias. The top surface of the PCB or the inside of the PCB includes a plurality of groups of through-current paths, the bottom surface of the PCB includes a plurality of groups of copper bars or aluminum bars, each group of through-current paths is configured to receive currents, and each group of copper bars or aluminum bars is configured to output currents. Each group of through-current paths includes two through-current paths that are configured to receive a positive current and a negative current respectively, and each group of copper bars or aluminum bars includes two copper bars or two aluminum bars that are configured to output a positive current and a negative current respectively.

The short lead-out pin is connected to one through-current path in one group of through-current paths through the via, the long lead-out pin is connected to one copper bar or aluminum bar in one group of copper bars or aluminum bars through the via, and the main lead-out pin components are configured to connect or disconnect a current transmission path between the one through-current path and the one copper bar or aluminum bar. The long lead-out pins of at least two of the plurality of the relays are connected to a same group of copper bars or aluminum bars, and the short lead-out pins of the at least two relays are connected to at least two groups of through-current paths in one-to-one correspondence.

The power distribution apparatus formed by assembling the relays 60 with the PCB is used, so that the power distribution apparatus can transmit a large current, has a good heat dissipation capability, and is applicable to a scenario in which an electric vehicle is charged at high power. In addition, the power distribution apparatus has a small volume.

Based on this, an embodiment of this application further provides a charging pile. The charging pile includes the foregoing power distribution apparatus, a power conversion apparatus, and a plurality of charging interfaces. The power conversion apparatus is configured to output a direct current to the power distribution apparatus, and the power distribution apparatus is configured to distribute the direct current to any one of the charging interfaces. Each charging interface is configured to connect to an electric vehicle.

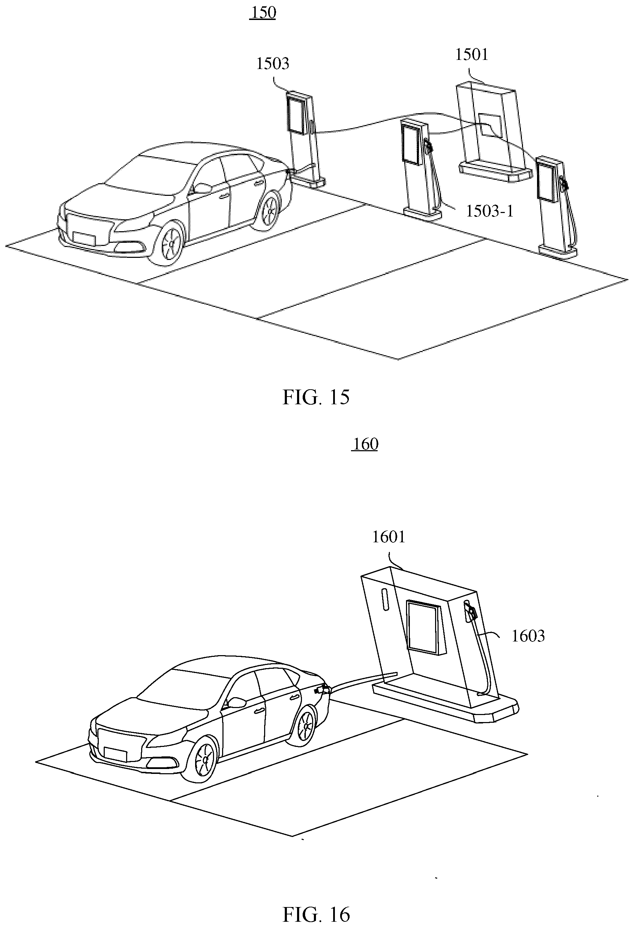

In a possible implementation, FIG. 15 is a diagram of a charging pile according to an embodiment of this application. The charging pile 150 is a split charging pile. The charging pile 150 includes a charging power unit 1501 and a plurality of charging terminals 1503. The charging power unit 1501 includes a power conversion apparatus (not shown in the figure) and the foregoing power distribution apparatus (not shown in the figure). The charging terminal 1503 includes a charging connector 1503-1, the charging connector 1503-1 includes a charging interface, and the charging interface is configured to be plugged into a charging socket of an electric vehicle. The power conversion apparatus in the charging power unit 1501 is configured to output a direct current to the power distribution apparatus, and the power distribution apparatus is configured to output the direct current to the charging interface.

In another possible implementation, FIG. 16 is another diagram of a charging pile according to an embodiment of this application. The charging pile 160 is an integrated charging pile. The charging pile 160 includes a charging power unit 1601 and a plurality of charging connectors 1603. The charging power unit 1601 includes a power conversion apparatus (not shown in the figure) and the foregoing power distribution apparatus (not shown in the figure). The charging connector 1603 includes a charging interface, and the charging interface is configured to be plugged into a charging socket of an electric vehicle. The power conversion apparatus is configured to output a direct current to the power distribution apparatus, and the power distribution apparatus is configured to output the direct current to the charging interface.

In a possible implementation, a contactor is further connected between the power distribution apparatus and each charging interface. The contactor is closed only when the charging interface is connected to an electric vehicle and the electric vehicle needs to be charged; otherwise, the contactor is in an open state. In this way, it can be ensured that the charging interface is not energized when the charging interface is not connected to an electric vehicle, so that charging safety of the charging pile is improved.

In a possible implementation, the power conversion apparatus includes a plurality of AC-DC modules. The plurality of AC-DC modules are configured to output direct currents to the power distribution apparatus. The power distribution apparatus controls on or off of a plurality of relays 60, to transmit a direct current to a charging interface connected to an electric vehicle.

In a possible implementation, the power conversion apparatus includes a plurality of AC-DC modules and a plurality of DC-DC modules. Output ends of the plurality of AC-DC modules are connected to input ends of the plurality of DC-DC modules through direct current buses, and output ends of the plurality of DC-DC modules are configured to output direct currents to the power distribution apparatus. The power distribution apparatus controls on or off of a plurality of relays 60, to transmit a direct current to a charging interface connected to an electric vehicle.

In a possible implementation, after a charging interface is connected to an electric vehicle, the charging pile is configured to obtain charging information of the electric vehicle, for example, a charging voltage and a charging current of the electric vehicle. The charging pile sends a control signal to the power distribution apparatus based on the charging information. The power distribution apparatus controls on or off of a plurality of relays 60 based on the control signal, so that the charging interface can output electric energy that matches the charging information of the electric vehicle.

The charging pile using the foregoing power distribution apparatus can have a strong through-current capability and a good heat dissipation capability, so that the charging pile can perform high-power ultra-fast charging on an electric vehicle. This facilitates implementation of a charging speed of 1 kilometer per second of the charging pile. In other words, this helps the charging pile supply, in 1 second to the electric vehicle, electric energy that allows the electric vehicle to travel 1 kilometer. In addition, this can reduce anxiety of a user about slow charging by the charging pile, and provide the user with charging experience of "full charging while enjoying a cup of coffee".

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A relay, wherein the relay comprises at least one group of main lead-out pin components and at least one group of main contact components, each group of main contact components is located inside the relay, each group of main lead-out pin components is connected to the main contact components, and each group of main lead-out pin components is configured to connect to a circuit to control connection or disconnection of the circuit;
the relay comprises a bottom wall, the bottom wall comprises an inner surface facing the inside of the relay and an outer surface facing the outside of the relay, and each group of main lead-out pin components is located on the outer surface of the bottom wall; and
each group of main lead-out pin components comprises a long lead-out pin and a short lead-out pin, and a length of the long lead-out pin is greater than a length of the short lead-out pin in a direction from the inner surface of the bottom wall to the outer surface of the bottom wall.

2. The relay according to claim 1, wherein the short lead-out pin is configured to connect to a through-current path on a top surface of a printed circuit board, PCB or inside the PCB through a via on the PCB, and the long lead-out pin is configured to connect to a copper bar or an aluminum bar on a bottom surface of the PCB through a via on the PCB.

3. The relay according to claim 1 or 2, wherein the bottom wall is in a quadrilateral shape, the bottom wall comprises a first edge and a second edge that are disposed opposite to each other and a third edge and a fourth edge that are disposed opposite to each other, the at least one group of main lead-out pin components comprises two groups of main lead-out pin components, and two long lead-out pins and two short lead-out pins in the two groups of main lead-out pin components are arranged at intervals in a circumferential direction of the bottom wall, wherein
one long lead-out pin and one short lead-out pin in the two groups of main lead-out pin components are arranged close to the first edge, the other long lead-out pin and the other short lead-out pin in the two groups of main lead-out pin components are arranged close to the second edge, and in a direction from the first edge to the second edge, a projection of the one long lead-out pin does not overlap a projection of the other long lead-out pin, and a projection of the one short lead-out pin does not overlap a projection of the other short lead-out pin; or
the short lead-out pins in the two groups of main lead-out pin components are disposed close to the first edge and the second edge respectively, and the long lead-out pins in the two groups of main lead-out pin components are disposed close to the third edge and the fourth edge respectively.

4. The relay according to claim 3, wherein when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, in a direction from the third edge to the fourth edge, a projection of the one long lead-out pin overlaps a projection of the one short lead-out pin, and a projection of the other long lead-out pin overlaps a projection of the other short lead-out pin.

5. The relay according to claim 3, wherein when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, at least one first insulation partition is disposed between the one long lead-out pin and the one short lead-out pin, and at least one second insulation partition is disposed between the other long lead-out pin and the other short lead-out pin.

6. The relay according to claim 5, wherein a first groove is provided between the one long lead-out pin and the one short lead-out pin, and a second groove is provided between the other long lead-out pin and the other short lead-out pin.

7. The relay according to claim 3, wherein when the short lead-out pins in the two groups of main lead-out pin components are disposed close to the first edge and the second edge respectively, and the long lead-out pins in the two groups of main lead-out pin components are disposed close to the third edge and the fourth edge respectively, the projections of the two short lead-out pins in the two groups of main lead-out pin components overlap in the direction from the first edge to the second edge, and projections of the two long lead-out pins in the two groups of main lead-out pin components overlap in a direction from the third edge to the fourth edge.

8. The relay according to any one of claims 3 to 7, wherein the relay further comprises a coil and a group of coil lead-out pin components, and the coil lead-out pin components are connected to the coil;
the at least one group of main contact components comprises two groups of main contact components, the two groups of main contact components are connected to the two groups of main lead-out pin components in one-to-one correspondence, each group of main contact components comprises a movable contact and a stationary contact, the long lead-out pin in each group of main lead-out pin components is connected to one of the movable contact and the stationary contact in the corresponding main contact components, and the short lead-out pin in each group of main lead-out pin components is connected to the other of the movable contact and the stationary contact in the corresponding main contact components; and
the coil is configured to drive the movable contact and the stationary contact in each of the two groups of main contact components to act with each other.

9. The relay according to claim 8, wherein the relay further comprises a group of auxiliary contact components and a group of auxiliary contact lead-out pin components, the group of auxiliary contact components is located inside the relay, the group of auxiliary contact lead-out pin components is located outside the relay, and the group of auxiliary contact lead-out pin components is connected to the group of auxiliary contact components; and
the group of auxiliary contact components comprises an auxiliary movable contact and an auxiliary stationary contact, and the auxiliary contact components are configured to be mechanically linked with each group of main contact components.

10. The relay according to claim 9, wherein when a movable contact and a stationary contact that are connected to at least one of the two groups of main lead-out pin components change from an open state to a closed state, a state between the auxiliary movable contact and the auxiliary stationary contact changes; or
when a movable contact and a stationary contact that are connected to each of the two groups of main lead-out pin components change from a closed state to an open state, a state between the auxiliary movable contact and the auxiliary stationary contact changes.

11. The relay according to claim 10, wherein when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, the coil lead-out pin components and the auxiliary contact lead-out pin components are arranged close to the third edge or the fourth edge; or
when the one long lead-out pin and the one short lead-out pin in the two groups of main lead-out pin components are arranged close to the first edge, and the other long lead-out pin and the other short lead-out pin in the two groups of main lead-out pin components are arranged close to the second edge, the coil lead-out pin components and the auxiliary contact lead-out pin components are located in a center of the bottom wall; or
when the short lead-out pins in the two groups of main lead-out pin components are disposed close to the first edge and the second edge respectively, and the long lead-out pins in the two groups of main lead-out pin components are disposed close to the third edge and the fourth edge respectively, the coil lead-out pin components and the auxiliary contact lead-out pin components are located in a center of the bottom wall.

12. The relay according to any one of claims 1 to 11, wherein the outer surface of the bottom wall comprises at least one protrusion, and a length of each of the at least one protrusion is less than a length of each lead-out pin in each group of main lead-out pin components in the direction from the inner surface to the outer surface.

13. The relay according to claim 12, wherein each lead-out pin in each group of main lead-out pin components comprises a first side surface and a second side surface that are disposed opposite to each other and a third side surface and a fourth side surface that are disposed opposite to each other, and a sum of areas of the first side surface and the second side surface is less than a sum of areas of the third side surface and the fourth side surface; and
a projection of each protrusion does not overlap a projection of each lead-out pin in each group of main lead-out pin components in a direction from the first side surface to the second side surface.

14. A power distribution apparatus, wherein the power distribution apparatus comprises a PCB and a plurality of the relays according to any one of claims 1 to 13, wherein vias are provided between a top surface and a bottom surface of the PCB, and the relays are connected to the PCB through the vias;
the top surface of the PCB or the inside of the PCB comprises a plurality of groups of through-current paths, the bottom surface of the PCB comprises a plurality of groups of copper bars or aluminum bars, each group of through-current paths is configured to receive currents, each group of copper bars or aluminum bars is configured to output currents, each group of through-current paths comprises two through-current paths that are configured to receive a positive current and a negative current respectively, and each group of copper bars or aluminum bars comprises two copper bars or two aluminum bars that are configured to output a positive current and a negative current respectively;
the short lead-out pin is connected to one through-current path in one group of through-current paths through the via, the long lead-out pin is connected to one copper bar or aluminum bar in one group of copper bars or aluminum bars through the via, and the main lead-out pin components are configured to connect or disconnect a current transmission path between the one through-current path and the one copper bar or aluminum bar; and
the long lead-out pins of at least two of the plurality of the relays are connected to a same group of copper bars or aluminum bars, and the short lead-out pins of the at least two relays are connected to at least two groups of through-current paths in one-to-one correspondence.

15. A charging pile, wherein the charging pile comprises the power distribution apparatus according to claim 14, a power conversion apparatus, and a plurality of charging interfaces, wherein each charging interface is configured to connect to an electric vehicle; and
the power conversion apparatus is configured to output a direct current to the power distribution apparatus, and the power distribution apparatus is configured to distribute the direct current to any one of the charging interfaces.
